# EUROPÄISCHE PATENTSCHRIFT

(11) **EP 0 803 171 B1**
(45) Veröffentlichungstag und Bekanntmachung des Hinweises auf die Patenterteilung: **05.04.2000**
(21) Anmeldenummer: 96900943.0
(22) Anmeldetag: 12.01.1996
(51) Int. Cl.: H05B 33/14, H05B 33/10

(54) **ELEKTROLUMINESZIERENDE ANORDNUNG**
ELECTROLUMINESCENT ARRANGEMENT
DISPOSITIF ELECTROLUMINESCENT

(30) Priorität: 13.01.1995 DE 19500912
(43) Veröffentlichungstag der Anmeldung: 29.10.1997
(73) Patentinhaber: BASF AKTIENGESELLSCHAFT, 67056 Ludwigshafen (DE)
(72) Erfinder: ETZBACH, Karl-Heinz, D-67227 Frankenthal (DE); MEYER, Frank, D-67063 Ludwigshafen (DE); PAULUS, Wolfgang, D-67256 Weisenheim (DE); SCHMIDT, Hans-Werner, D-95445 Bayreuth (DE)
(86) Internationale Anmeldenummer: EP9600113
(87) Internationale Veröffentlichungsnummer: WO9622005

(56) Entgegenhaltungen:
- EP-A- 0 637 899
- WO-A-88/04467

## Beschreibung

Gegenstand der vorliegenden Erfindung ist eine elektrolumineszierende Anordnung, enthaltend eine oder mehrere organische Schichten, von denen mindestens eine durch thermische oder strahlungsinduzierte Vernetzung erhalten wird und die pro Schicht mindestens eine ladungstransportierende Verbindung, welche vernetzbare Gruppen tragen kann, enthält, dadurch gekennzeichnet, daß eine der Schichten ganz oder teilweise aus einer vernetzbaren fluoreszierenden Verbindung aufgebaut wird, welche radikalisch, anionisch oder kationisch vernetzbare oder zur Photocycloaddition fähige Gruppen enthält, die über Spacer an die fluoreszierenden Verbindungen gebunden sind, wobei als Spacer Gruppen der Formeln 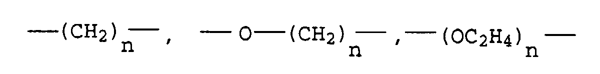 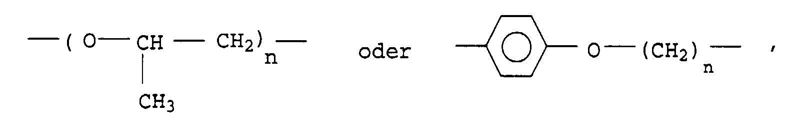 wobei n eine Zahl von 1 bis 12 bedeutet,
verwendet werden,
und daß die Verbindung Fluoreszenzlicht im Wellenlängenbereich von 400 bis 800 nm abstrahlt, ausgenommen die Verbindungen 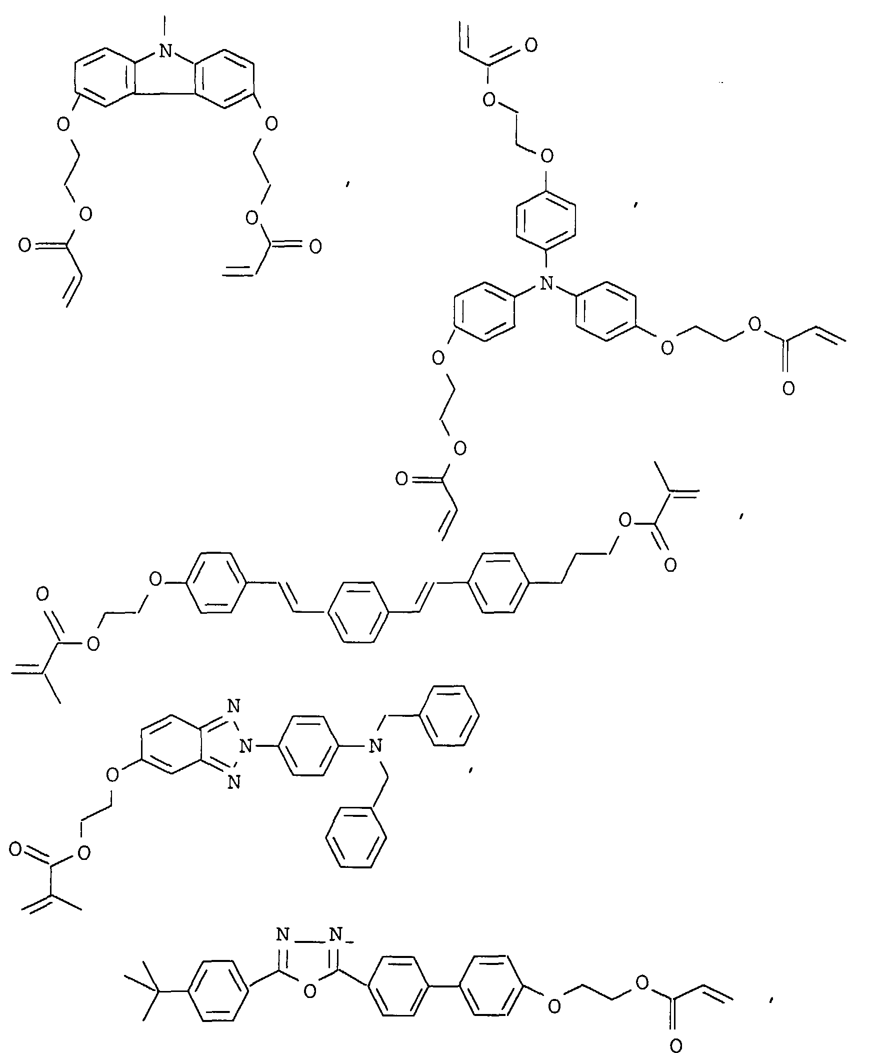 und 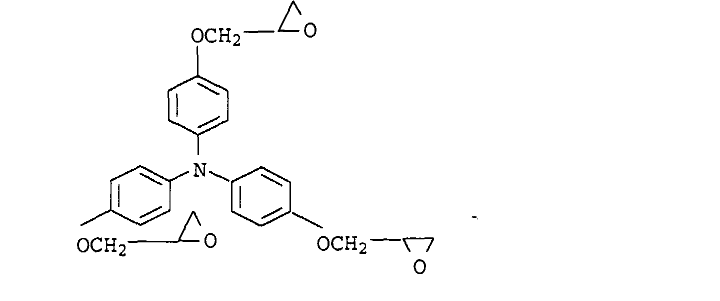 als fluoreszierende Verbindungen.

Weiterhin betrifft die Erfindung ein Verfahren zur Herstellung solcher elektrolumineszierender Anordnungen.

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher") und negative Ladungen (Elektronen) unter Aussendung von Licht kombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

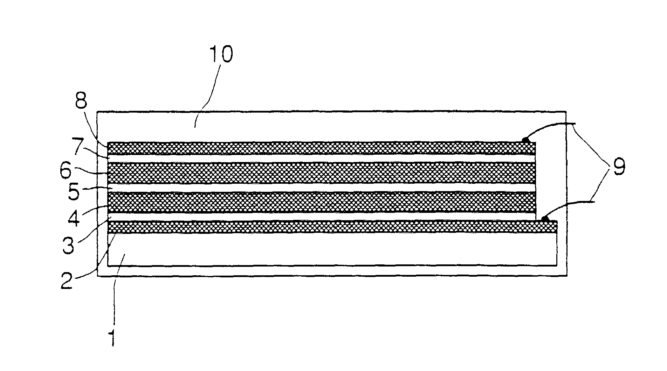

Diese organischen EL-Anordnungen enthalten in der Regel eine oder mehrere Schichten aus organischen Ladungstransportverbindungen. Der prinzipielle Aufbau ist in der Figur dargestellt. Die Zahlen 1 bis 10 bedeuten dabei:
1 Träger, Substrat
2 Basiselektrode
3 Löcher-injizierende Schicht
4 Löcher-transportierende Schicht
5 Emitter-Schicht
6 Elektronen-transportierende Schicht
7 Elektronen-injizierende Schicht
8 Topelektrode
9 Kontakte
10 Umhüllung, Verkapselung

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der der Emission von Licht - erfüllt. Derartige Systeme sind z.B. in der Anmeldung WO 9013148 auf der Basis von Poly-[p-phenylenvinylen] beschrieben.

In der Literatur wird eine Vielzahl von organischen Verbindungen beschrieben, die Ladungen (Löcher und/oder Elektronen) transportieren. Verwendet werden überwiegend niedermolekulare Substanzen, die z.B. im Hochvakuum aufgedampft werden. Einen guten Überblick über die Substanzklassen und ihre Verwendung geben z.B. die Veröffentlichungen EP-A-387715, US-A-4539507, 4720432 und 4769292. Im Prinzip kann man z.B. alle Substanzen verwenden, die als Photoleiter aus der Elektrophotographie bekannt sind.

Allen diesen EL-Anordnungen, welche auf niedermolekularen Verbindungen basieren, ist gemeinsam, daß sie keine ausreichende Betriebs-Lebensdauer haben. Während des Betriebs werden die organischen Leuchtdioden sehr heiß (> 100°C), und dies führt zu einer Veränderung der Schichten bis hin zu ihrer Zerstörung, so daß dann eine Leistungsminderung oder völliger Verlust der Funktion eintritt.

Diese Probleme sollten bei der Verwendung von Polymeren in EL-Anordnungen weniger stark ausgeprägt auftreten. Schichten, die Polymere enthalten, sind jedoch nur wenige beschrieben. So wird z.B. eine EL-Anordnung in der japanischen Offenlegungsschrift JP 4028197 geschildert, welche Polyvinylcarbazol als Bestandteil der Emitterschicht enthält. Das Aufbringen von löslichen Polymeren, wie Polyvinylcarbazol, geschieht mittels Gießen oder Aufschleudern (spin-coating) verdünnter Lösungen. Nachteilig bei diesem Verfahren ist, daß mehrere Schichten auf diese Art nicht aufgebracht werden können, da das Lösungsmittel für die zweite Schicht die erste Schicht anlöst oder zumindest anquillt. Dies führt dann zu einer Vermischung der beiden Schichten an der Grenzfläche und damit zu einer Verringerung der Effizienz. Diese Probleme werden in US-A 4 539 507 ausführlich beschrieben.

Außerdem ist zu beachten, daß die thermische Stabilität von Polymerschichten nicht nur chemisch (Zersetzung), sondern auch physikalisch durch ihre Glas- oder Schmelztemperatur begrenzt ist.

Weitere Beispiele für den Einsatz von Polymeren in EL-Anordnungen sind Poly[p-phenylenvinylen] (PPV) und Polyimide. Die Verwendung von PPV in EL-Anordnungen wird in den Dokumenten EP-A-443861, WO-A-9013148, 9203490 und 9203491 beschrieben. Als Vorteil kann die hohe thermische Stabilität des PPV angeführt werden, welches außerdem unlöslich ist.

Polyimid-Schichten werden durch Aufdampfen entsprechender Comonomerer im Hochvakuum und anschließende thermische Bildung des Polyimids erhalten (siehe EP-A-449125). Diese Polymeren sind ebenfalls unlöslich.

Für Anwendungen im EL-Bereich (insbesondere Anzeigeelemente, Displays) gilt diese Unlöslichkeit wegen der dadurch nicht mehr möglichen Photostrukturierbarkeit als Nachteil. Außerdem beschränkt die zur Herstellung der Polymeren erforderliche thermische Behandlung der Schichtträger die Auswahl auf hochtemperaturstabile Substrate, z.B. Glas.

In der älteren europäischen Patentanmeldung 0 637 899 wird eine elektrolumineszierende Anordnung beschrieben, welche in wesentlichen Merkmalen mit der Anordnung gemäß der vorliegenden Erfindung übereinstimmt. Unterschiede bestehen jedoch in den strukturellen Eigenschaften der verwendeten fluoreszierenden Verbindungen. Während diese in der älteren Patentanmeldung typischerweise polymerisierbare Gruppen tragen, welche direkt an die restliche Moleküleinheit angebunden sind, kommen hier solche Verbindungen zur Verwendung, in welchen polymerisierbare Gruppen, über die eingangs erwähnten Spacer angebunden, enthalten sind. Die in der älteren Patentanmeldung (zufällig) aufgeführten Verbindungen, welche Spayer enthalten, sind dabei explizit ausgenommen.

Aufgabe der Erfindung war es daher die beschriebenen Nachteile des Standes der Technik zu vermeiden.

Demgemäß wurden die eingangs definierten elektrolumineszierenden Anordnungen gefunden.

Der Aufbau dieser EL-Anordnungen entspricht prinzipiell dem in der Figur gezeigten Schema, wobei, wie schon angegeben, die Zahl der organischen Schichten vermindert werden kann, wenn einzelne Schichten mehrere Funktionen übernehmen.

Diese Kombination mehrerer Funktionen in einer Schicht betrifft vor allem die Schichten 3 bis 7. Bei dem Aufbau der EL-Anordnung kann z.B. auf die Elektronenleiterschicht und die elektronen-injizierende Schicht verzichtet werden. Die EL-Anordnung würde dann z.B. neben den Elektroden und dem Substrat aus den Schichten 3 bis 5 bestehen.

Die Schichten weisen vorzugsweise eine Dicke von 10 nm bis 10 µm auf.

Im folgenden werden unter Ladungstransportverbindungen alle Verbindungen verstanden, die in irgendeiner Art und Weise Ladungen (Löcher und/oder Elektronen) transportieren. Darunter fallen auch ausdrücklich diejenigen Verbindungen, die Bestandteile der Emitter-Schicht sind, also photolumineszierende Materialien darstellen, wie z.B. Fluoreszenzfarbstoffe.

Bei dem erfindungsgemäßen schichtweisen Aufbau der EL-Anordnung werden die Bestandteile der einzelnen Schichten thermisch oder besonders bevorzugt mit aktinischer Strahlung (z.B. UV-Licht, sichtbares Licht, Elektronenstrahlen oder Röntgenstrahlen) vernetzt. Zunächst wird ein geeignetes Substrat beschichtet. Als Substrate eignen sich z.B. leitfähig beschichtete Gläser und Folien, die mechanisch stabil sind. Das Substrat und die Elektroden sollten bei der Wellenlänge des emittierten Lichtes möglichst wenig absorbieren. In der Regel wird eine entsprechende Lösung, die die Ladungstransportverbindungen neben weiteren, optionalen Bestandteilen wie Bindemitteln, Reaktivverdünnern, Vernetzern und thermischen oder Photo-Initiatoren, enthält, auf ein Substrat aufgeschleudert oder gerakelt, und nach eventueller Trocknung wird der entstandene Film thermisch oder, besonders bevorzugt, mittels aktinischer Strahlung vernetzt. Vorteil letzterer Ausführungsform ist, daß das Substrat kaum thermisch belastet wird. In jedem Fall kann - je nach geplantem Aufbau - nach der Vernetzung sogleich die nächste Schicht aufgebracht werden. Aufgrund der Ausbildung eines unlöslichen polymeren Netzwerks in der gerade behandelten Schicht kann eine Vermischung der frisch-aufgebrachten mit der bereits vernetzten Schicht nicht auftreten. Bei der strahlungsinduzierten Vernetzung können die Schicht oder Schichten durch bildmäßige Belichtung nach bekannten Methoden natürlich auch strukturiert werden, wobei nicht belichtete Stellen durch Auswaschen entfernt werden können. Auf Vernetzung basierende, photostrukturierbare Systeme sind in der Technik bekannt (Druckplatten, Photoresiste).

Ebenfalls möglich ist die Kombination von vernetzten mit unvernetzten Schichten, die auf bekannte Art erhalten werden, beispielsweise durch Aufdampfen oder Aufrakeln und gegebenenfalls anschließendes Fixieren.

Als ladungstransportierende Verbindungen in den Schichten können erfindungsgemäß alle Verbindungen verwendet werden, die in irgendeiner Art und Weise Ladungen (Locher und/oder Elektronen) transportieren. Darunter fallen, wie schon gesagt, auch ausdrücklich diejenigen Verbindungen, die Bestandteile der Emitter-Schicht sind, also photolumineszierende Materialien darstellen, wie Fluoreszenzfarbstoffe. Besonders geeignet sind solche Verbindungen, die anionisch, kationisch oder vorzugsweise radikalisch polymerisierbare Gruppen tragen. Ebenfalls bevorzugt sind solche Ladungstransportverbindungen, welche zur Photocycloaddition fähige Gruppen tragen.

Als Grundkörper der ladungstransportierenden Verbindungen können aufgeführt werden: tertiäre aromatische Amine, Oxadiazole, Thiadiazole, Benzoxazole, Benztriazole, Naphthalimide, Bisstyryle, Cumarine, Benzofurane, Dibenzanthrone, Phthalocyanine, kondensierte aromatische Systeme, wie Perylene, Pyrene oder Coronene oder Polyenverbindungen, welche vorzugsweise zusätzlich kationisch oder radikalisch polymerisierbare Gruppen oder zur Photocycloaddition fähige Gruppen tragen. Bevorzugt sind solche Verbindungen, die neben ladungstransportierenden auch fluoreszierende Eigenschaften aufweisen. Hervorzuheben sind darunter Verbindungen aus der Klasse der Perylene, Naphthalimide, Dibenzanthrone, Pyrene, Benztriazole, Oxadiazole, Bisstyryle, Benzoxazole, Cumarine oder Benzofurane sowie Violanthrone und Isoviolanthrone. Besonders bevorzugt sind darunter Verbindungen aus der Klasse der Perylene, Naphthalimide, Violanthrone und Isoviolanthrone. Derartige Verbindungen werden vorzugsweise in die Schichten 3, 4, 6 und 7, oder in Kombinationen derselben, eingebracht.

Als erfindungsgemäß lichtaussendende, d.h. fluoreszierende Verbindungen, die Licht von Wellenlänge zwischen 400 und 800 mm aussenden, kommen insbesondere fluoreszierende Verbindungen in Betracht, die anionisch, kationisch oder vorzugsweise radikalisch polymerisierbare Gruppen tragen. Ebenfalls eignen sich solche fluoreszierenden Verbindungen, die sich thermisch oder durch Photocycloaddition vernetzen lassen. Die vernetzbaren fluoreszierenden Verbindungen können dabei als solche oder in Kombination mit anderen vernetzbaren Verbindungen eine oder mehrere Schichten der elektrolumineszierenden Anordnung bilden, bevorzugt ist dabei die Schicht 5. Die Polymerisation (Vernetzung) kann mit oder ohne Zusatzstoffe wie Reaktiverdünnern, Vernetzern oder Bindemitteln ausgeführt werden.

Die Perylenverbindungen leiten sich dabei vorzugsweise von 3,4,9,10-Perylencarbonsäuren oder Derivaten davon ab, die zusätzlich noch in der 1-,6-,7- oder 12-Stellung durch Chlor, Brom, C₁- bis C₆-Alkoxy oder Phenoxy substituiert sein können. Naphthalimidverbindungen tragen insbesondere am Imidstickstoff und in den Positionen 4 und 5 Substituenten und/oder vernetzbare Gruppen. Violanthron- und Isoviolanthronverbindungen tragen die vernetzenden Gruppen vorzugsweise über Sauerstoff verknüpft in den Positionen 16 und 17 oder 6 und 15.

Benztriazole entsprechen vorzugsweise der allgemeinen Formel 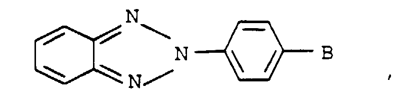 in der
- B: eine über Sauerstoff oder Stickstoff gebundene vernetzbare Gruppe bedeutet und bei denen der Benz- und/oder Phenylenrest noch durch Chlor, Brom, Alkyl oder Alkoxy oder vernetzbare Gruppen substituiert sein können.

Einzelne fluoreszierende Verbindungen sind z.B.:

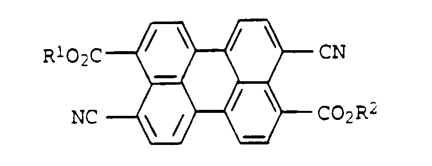

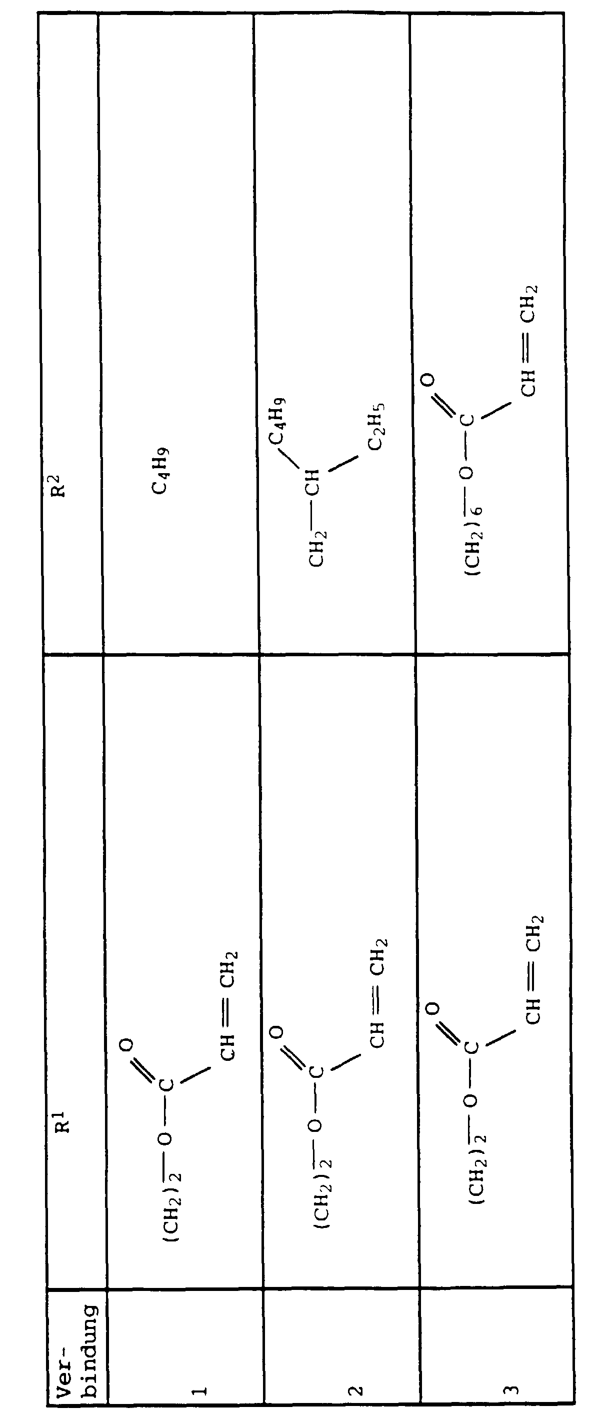

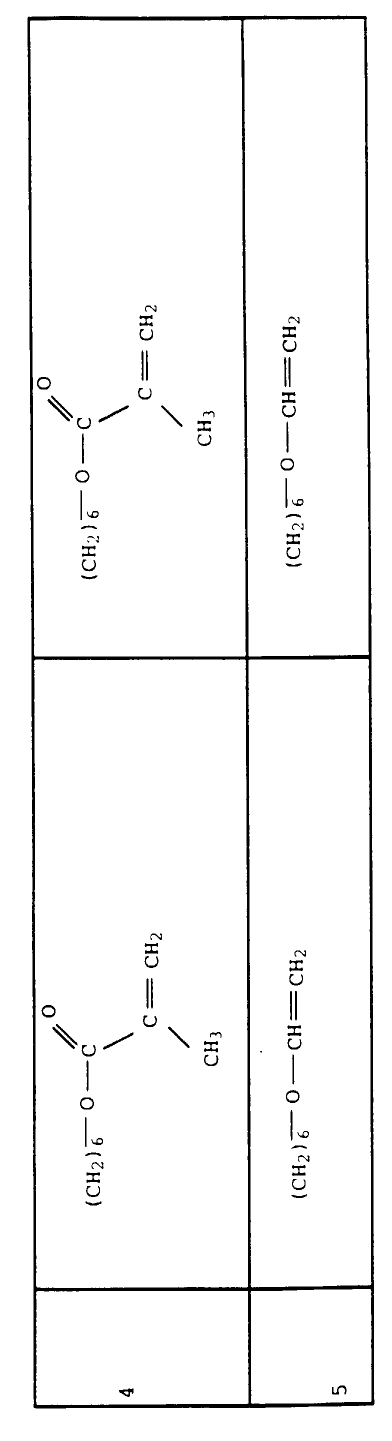

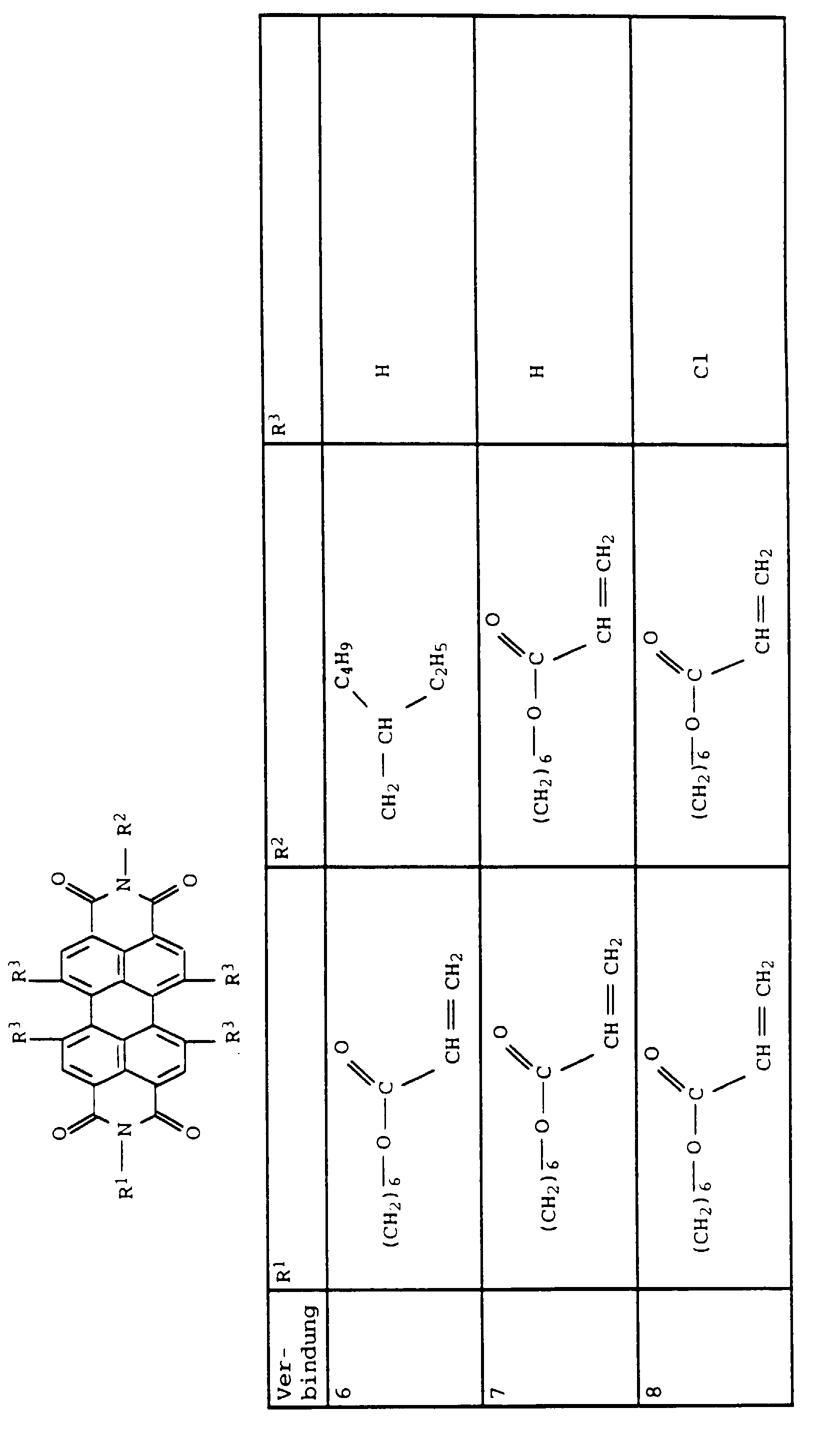

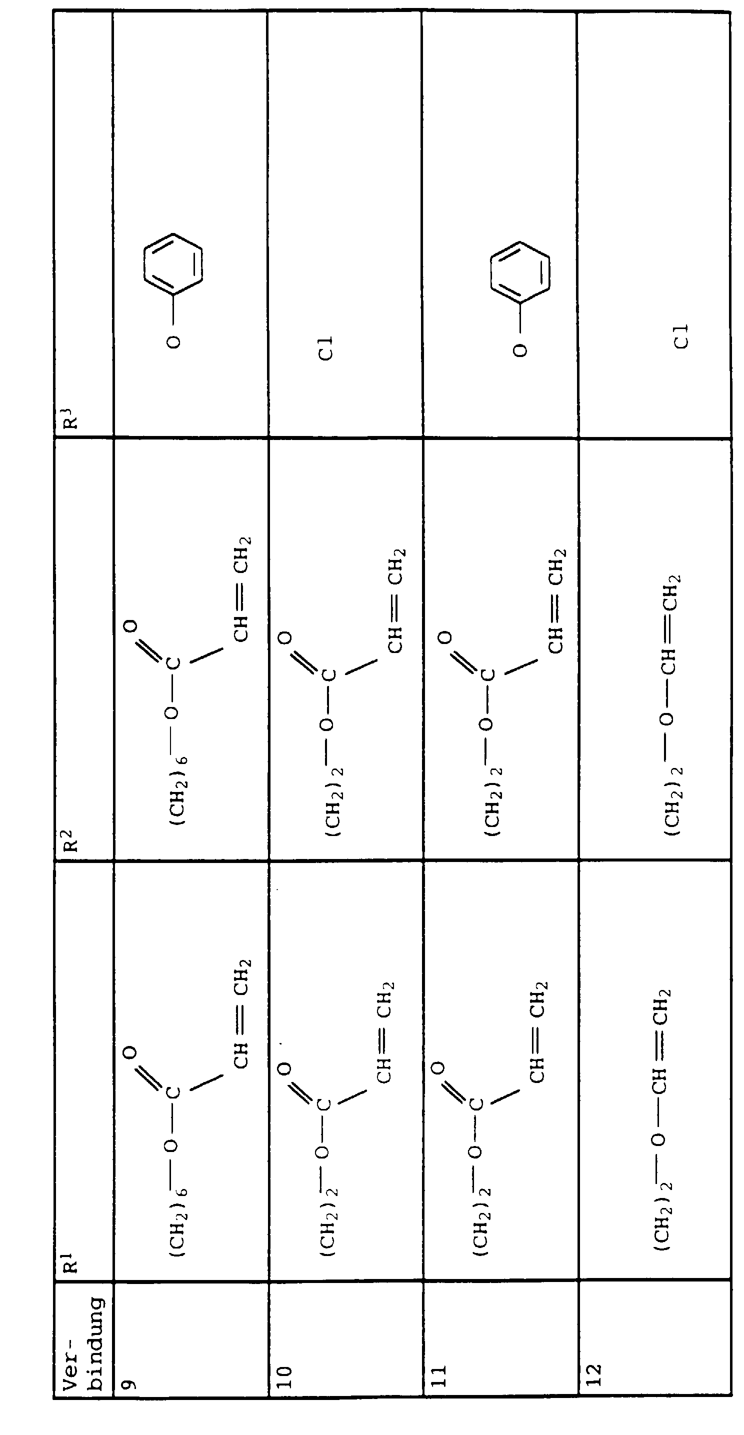

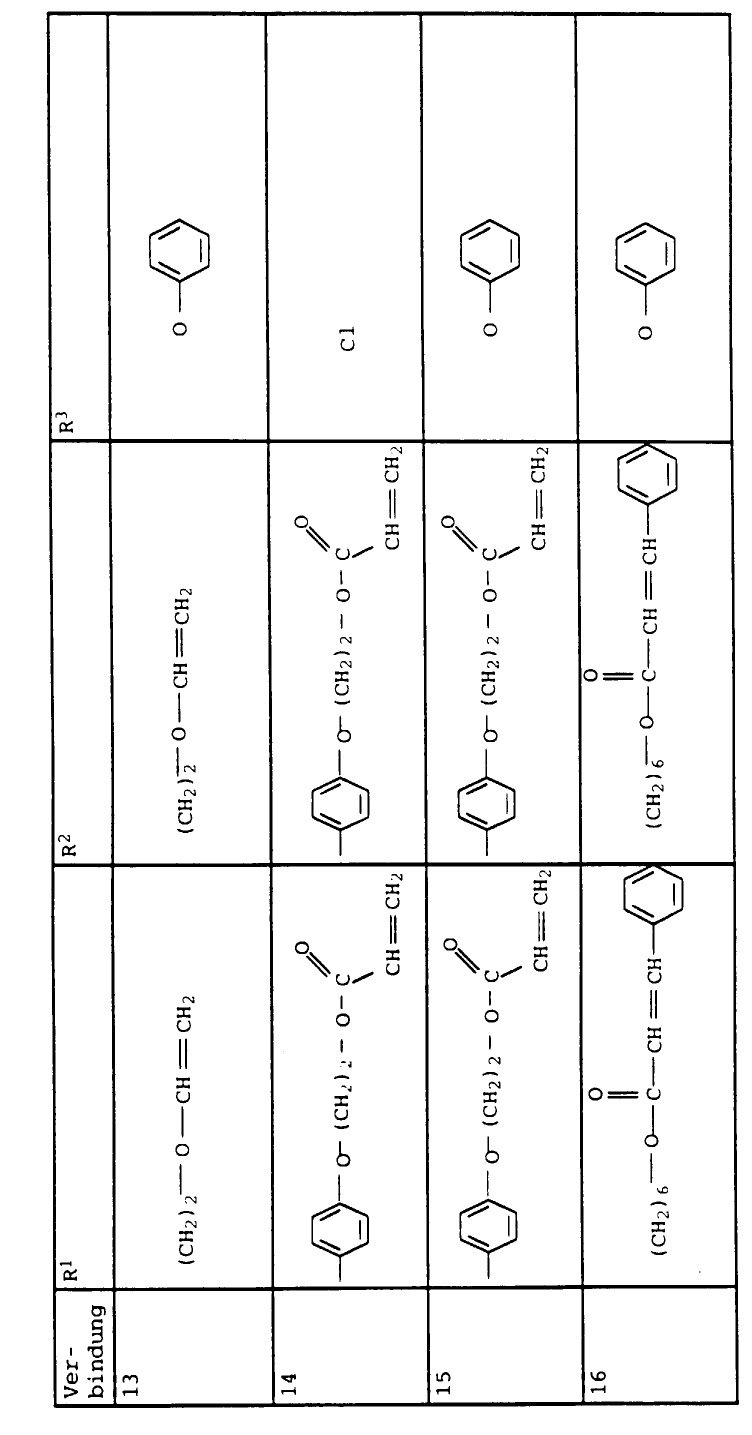

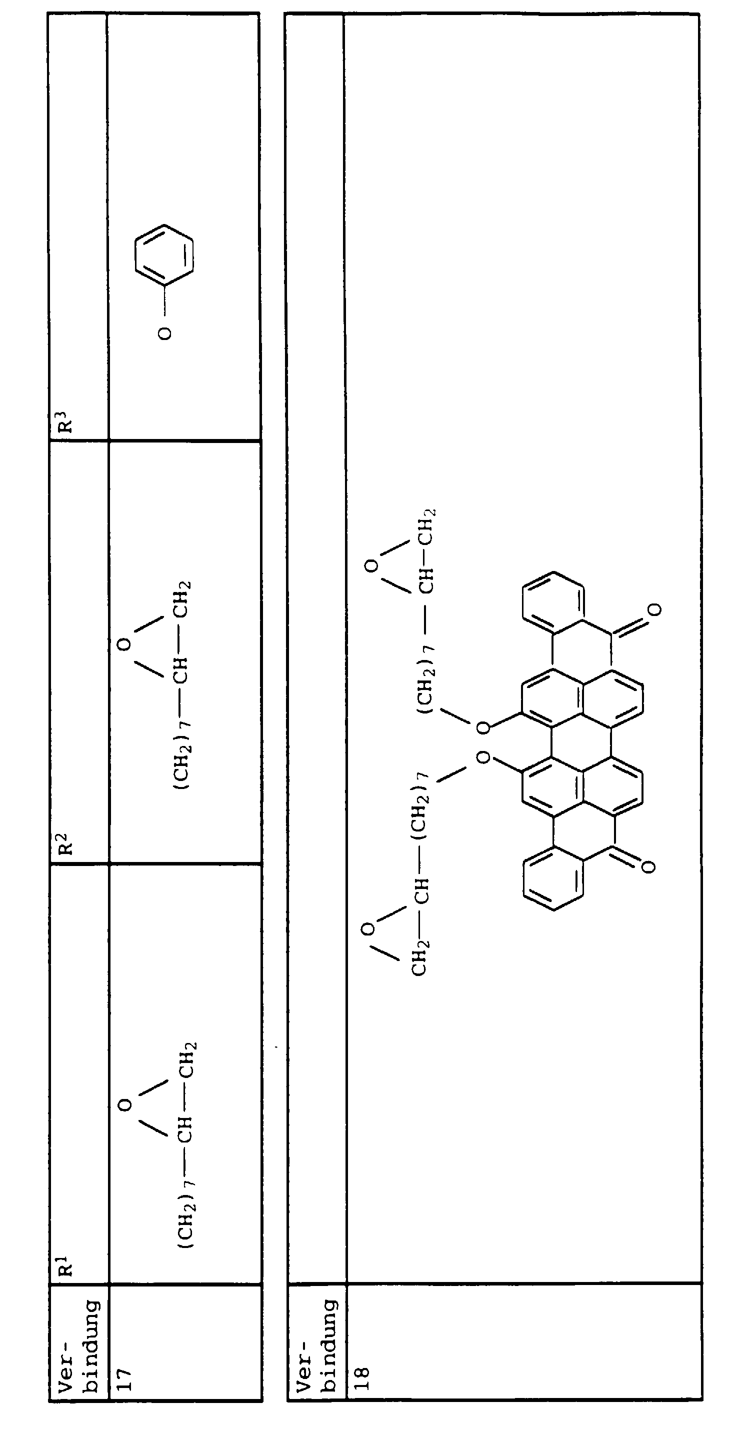

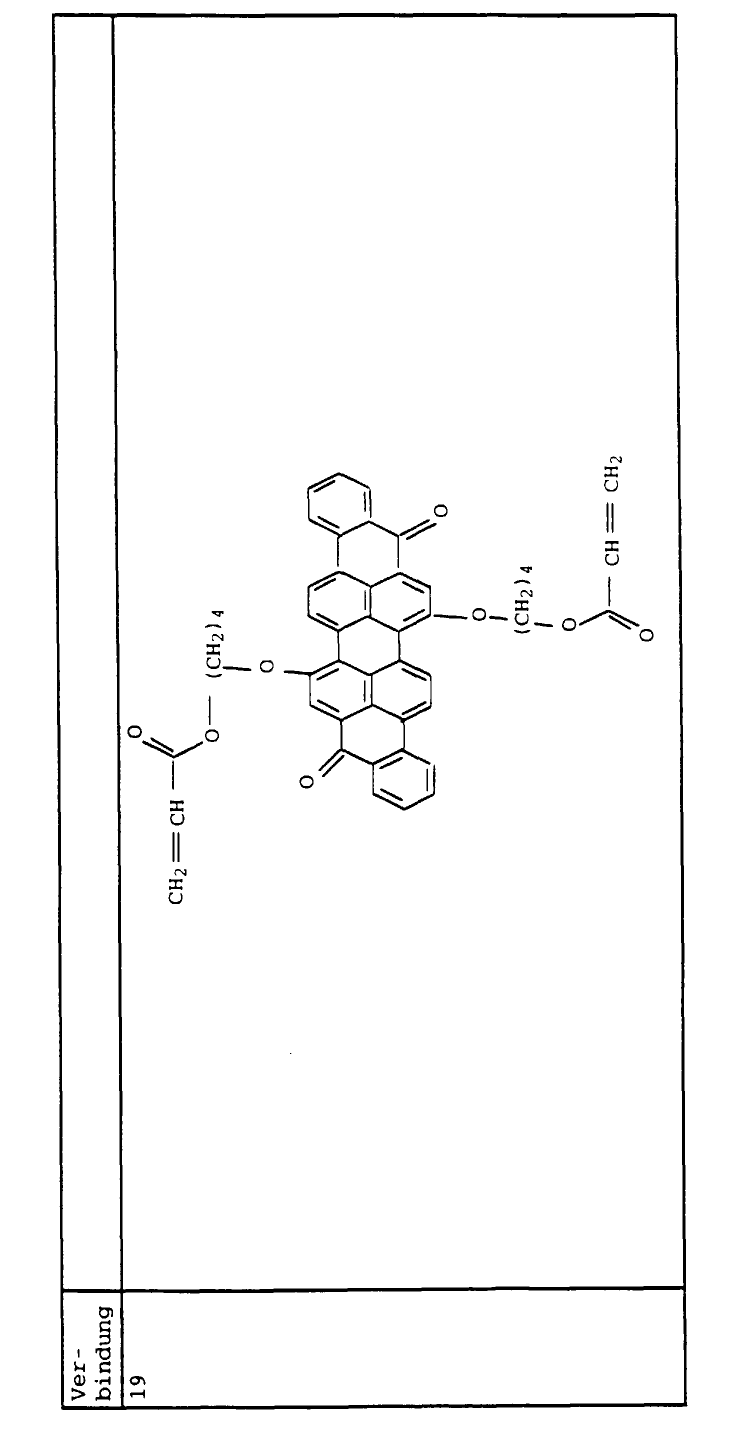

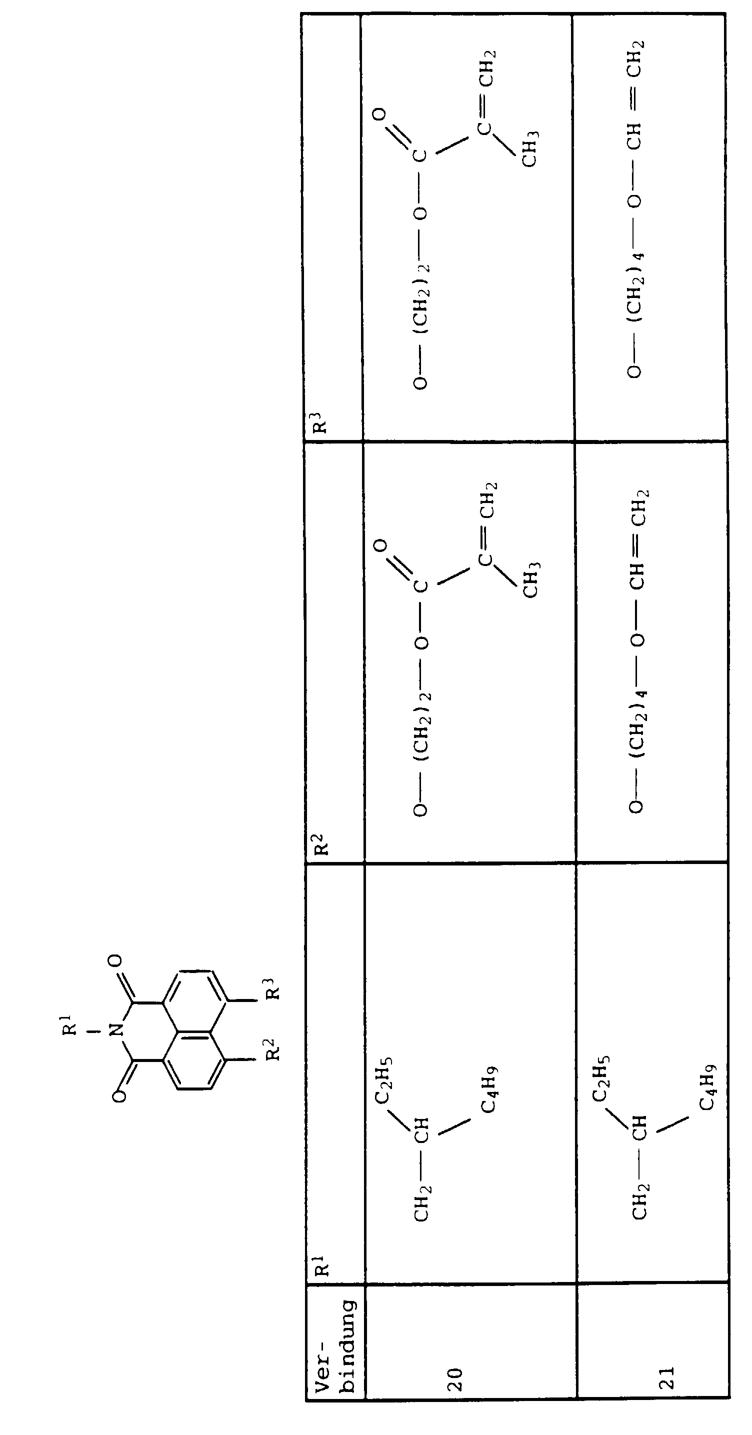

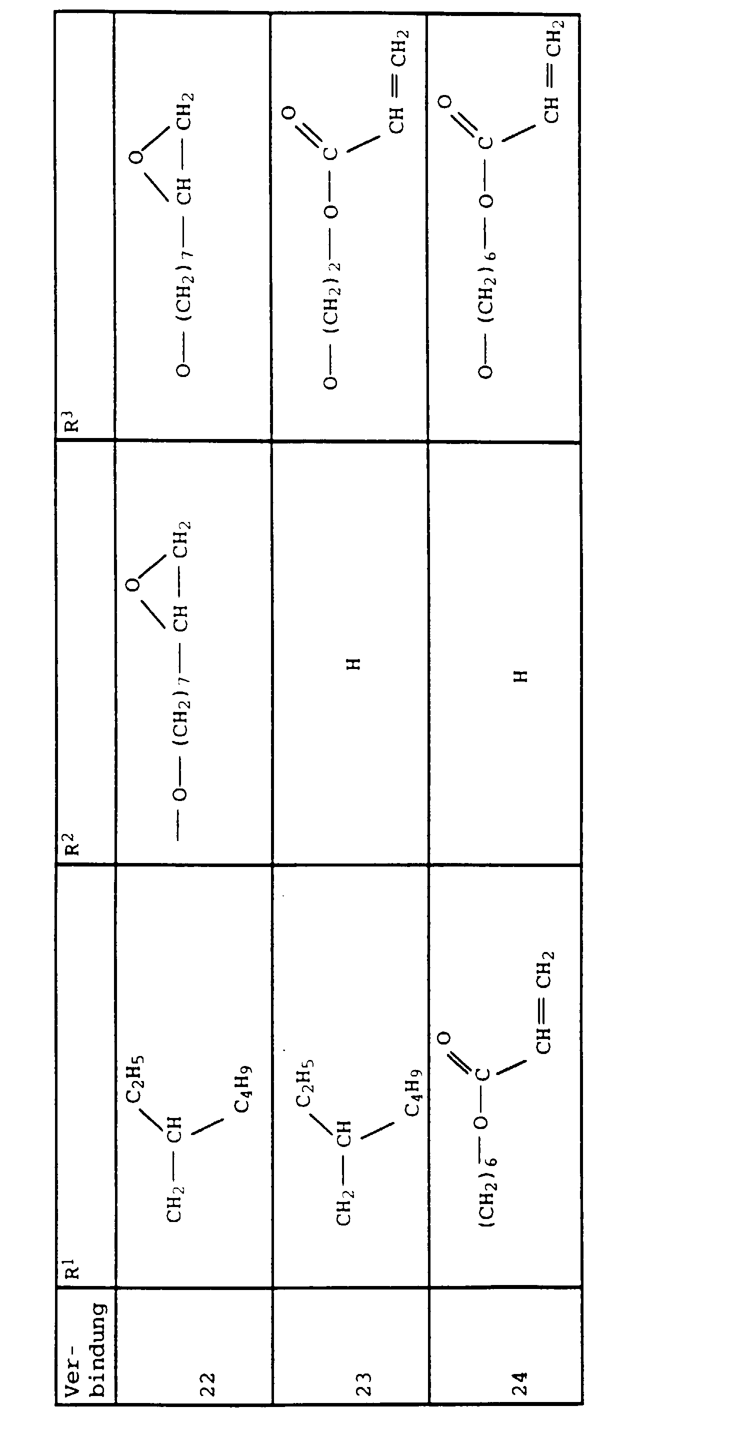

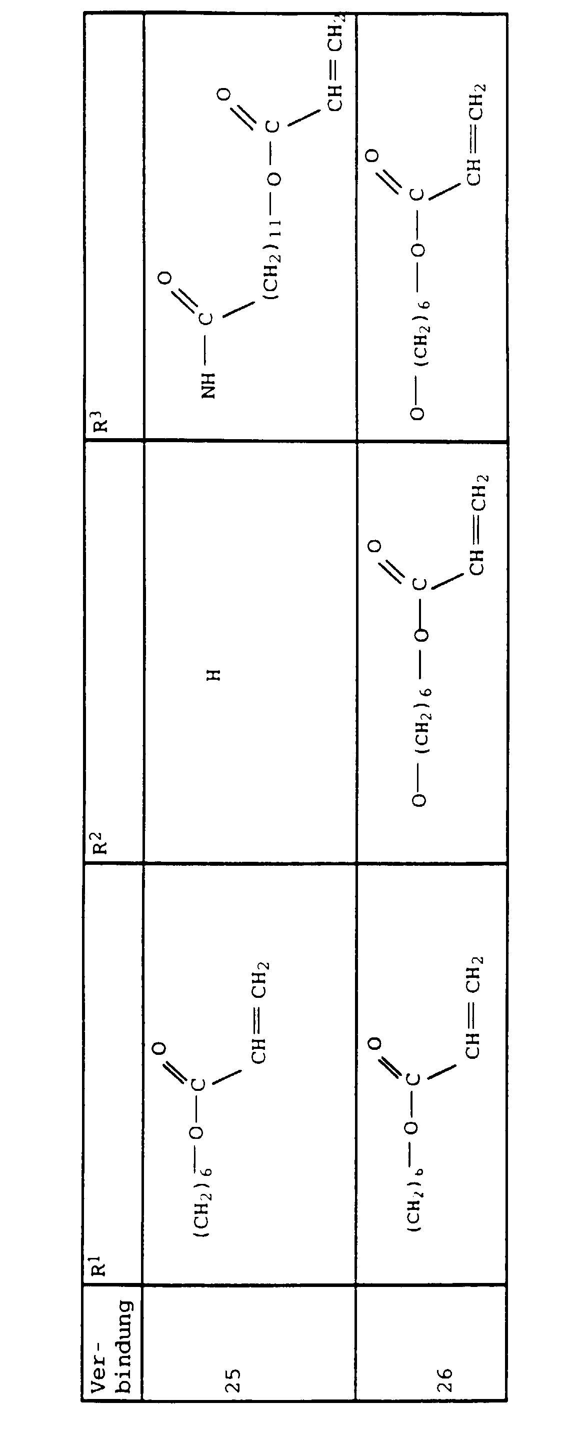

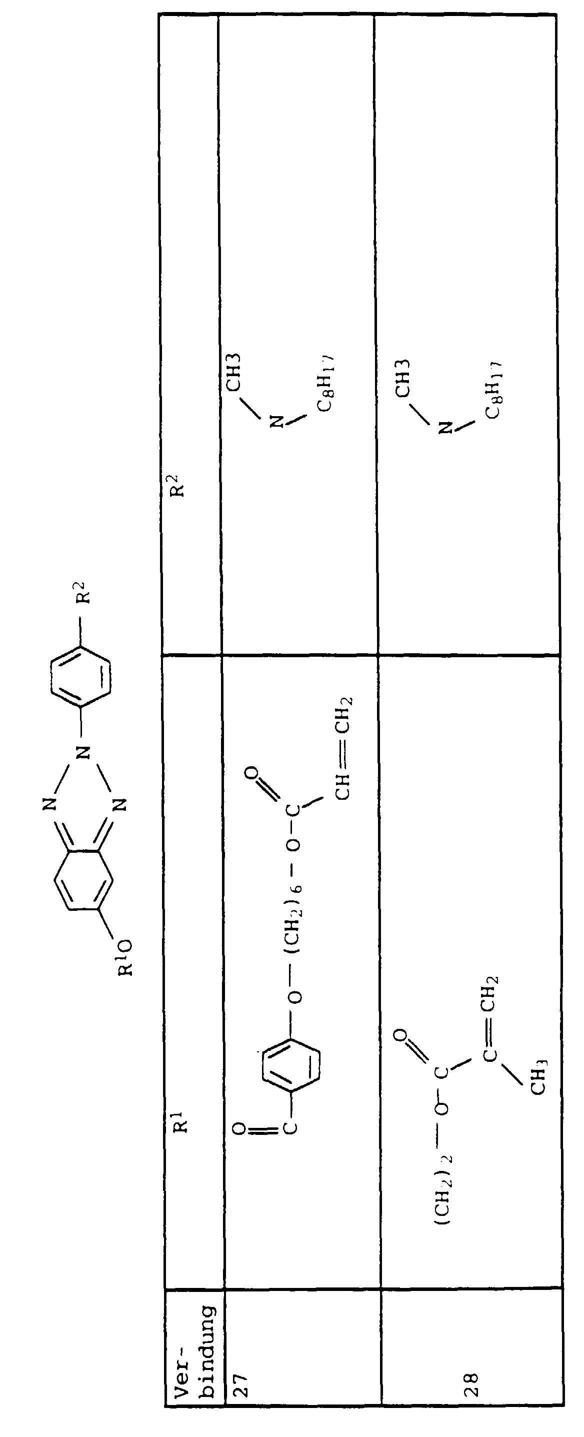

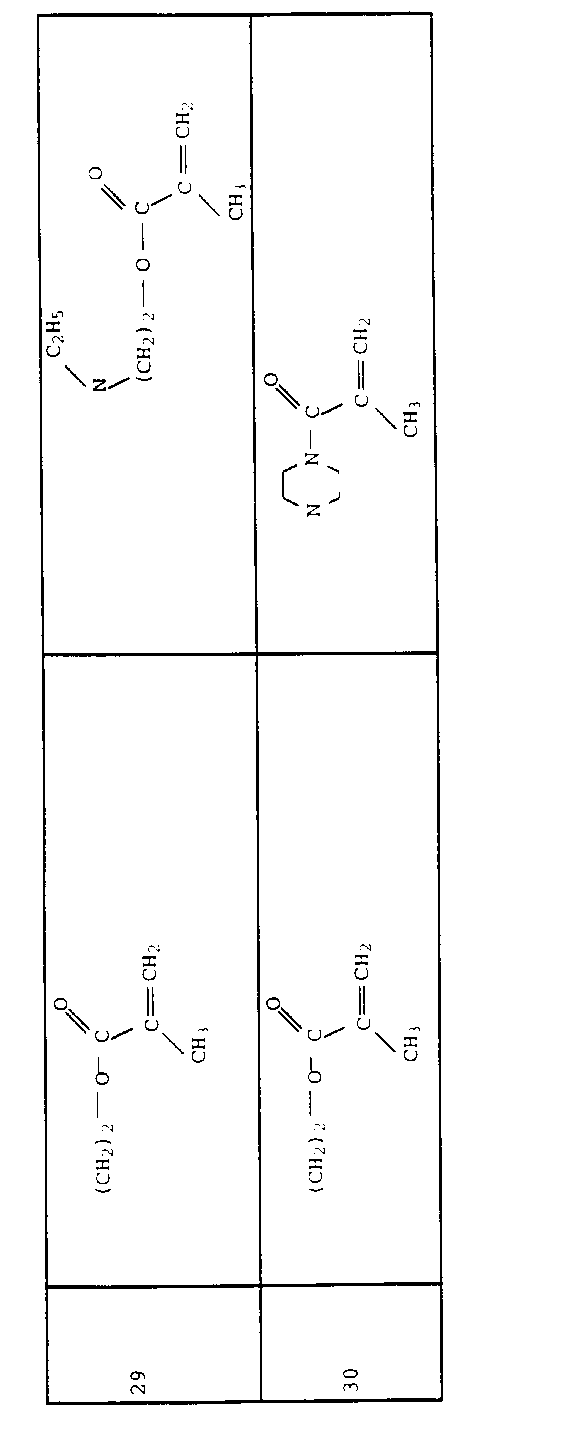

Radikalisch polymerisierbare Gruppen sind solche, bei denen die Polymerisation mit Radikalen gestartet wird. Beispiele derartiger Gruppen sind insbesondere Vinylverbindungen, darunter besonders Vinylcarbonylverbindungen, wie Acrylate, Methacrylate, oder Maleinsäurederivate.

Unter kationisch polymerisierbaren Gruppen werden Gruppen verstanden, die mit Protonensäuren oder Lewis-Säuren unter Bildung von Polymeren reagieren. Beispiele für derartige Verbindungen sind Vinylether und Epoxide.

Anionisch polymerisierbare Verbindungen sind z.B. Cyanacrylate, Methacrylate oder Styrol.

Die fluoreszierenden Verbindungen enthalten radikalisch, anionisch oder kationisch vernetzbare oder zur Photocycloaddition befähigte Gruppen, welche über Spacer der Formeln 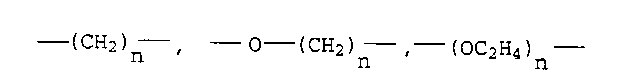 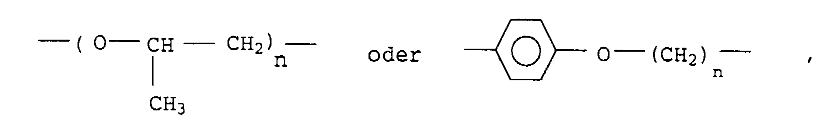 wobei n eine Zahl von 1 bis 12 bedeutet, an die fluoreszierenden Verbindungen gebunden sind.

An eine fluoreszierende Verbindung können natürlich eine oder mehrere anionisch, kationisch oder vorzugsweise radikalisch polymerisierbare Gruppen gebunden sein. Die Verwendung von mehr als einer anionisch, kationisch oder radikalisch polymerisierbaren Gruppe ist bevorzugt, da eine Netzwerk-Bildung dabei leichter gelingt.

Zur Photocycloaddition fähige Seitengruppen sind ebenfalls bevorzugt als Substituenten für die erfindungsgemäßen fluoreszierenden Verbindungen. Beispiele derartiger Seitengruppen sind: 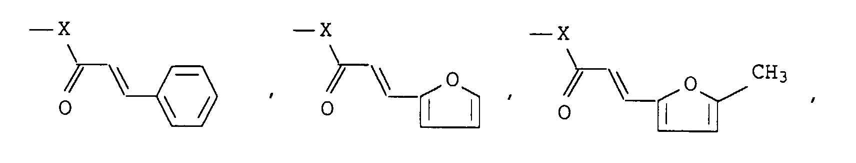 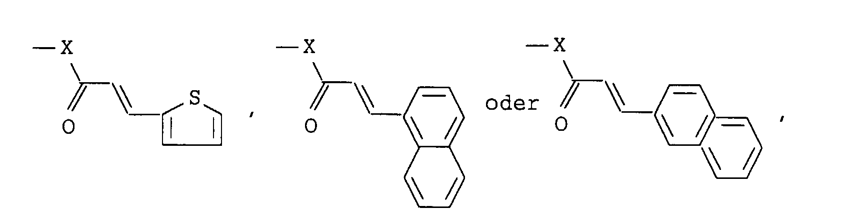 wobei X O oder NR ist und die Reste noch weiter, beispielsweise durch Methyl oder Methoxy substituiert sein können und R Wasserstoff oder C₁ bis C₆-Alkyl, vorzugsweise Methyl oder Ethyl, bedeutet.

Anstelle einheitlicher zur Vernetzung führender Substituenten können auch Kombinationen der verschiedenen vernetzbaren Substituenten an einem fluoreszierenden Molekül verwendet werden. So kann z.B. an einem fluoreszierendem Molekül eine radikalisch vernetzbare Gruppe, wie ein Acrylsäureester, neben einer zur Photocycloaddition fähigen Gruppe, z.B. einem Zimtsäurederivat vorliegen.

Neben den fluoreszierenden Verbindungen können die Lösungen zur Herstellung der erfindungsgemäßen Schichten, wie bereits gesagt, beispielsweise noch (thermische und photochemische) Initiatoren, Bindemittel, Reaktivverdünner, Vernetzer und Verlaufshilfsmittel enthalten, die dem Fachmann aus der Lacktechnik bekannt sind.

Vorzugsweise enthalten die Schichten der elektroluminizierenden Anordnung neben der ladungstransportierenden und fluoreszierenden Verbindung zusätzlich mindestens ein vernetzbares polymeres Bindemittel und/oder mindestens eine vernetzbare niedermolekulare Verbindung.

Zur Herstellung der erfindungsgemäßen Schichten werden zweckmäßigerweise die fluoreszierenden Verbindungen gegebenenfalls zusammen mit einem kationisch oder radikalisch wirkenden Initiator, Bindemittel und Reaktivverdünner in einem Lösungsmittel, in dem sie gut löslich sind, gelöst und mittels einer Rakel oder einer Schleuder auf das bereits mit einer Elektrode beschichtete Substrat aufgebracht. Nach dem Verdunsten des Lösungsmittels, was ggf. durch leichtes Erwärmen beschleunigt werden kann, wird der resultierende Film mittels aktinischer Strahlung oder durch Erwärmung vernetzt. Die entsprechenden Verfahren (z.B. UV-Härtung, Elektronenstrahlhärtung) sind aus der Lacktechnologie bekannt und bieten demgegenüber keine Besonderheiten, üblicherweise werden bei UV Wellenlängen von 200 bis 450 nm und bei Elektronenstrahlen Energien von 0,3 bis 1 MeV verwendet. Bei der durch Strahlung bewirkten Vernetzung lassen sich die Schichten direkt strukturieren, was z.B. für die Display-Herstellung wichtig ist. Dies geschieht in der Regel analog zu den aus der Resist-Technologie bekannten Verfahren.

Die erhaltene, vernetzte Schicht ist thermisch stabil, unlöslich und mechanisch belastbar. Je nach gewünschter Ausführung können analog weitere Schichten oder sofort die zweite Elektrode, z.B. durch Aufdampfen, aufgebracht werden. Derartige EL-Anordnungen zeichnen sich durch eine besonders gute thermische Belastbarkeit aus.

## Patentansprüche

1. Elektrolumineszierende Anordnung, enthaltend eine oder mehrere organische Schichten, von denen mindestens eine durch thermische oder strahlungsinduzierte Vernetzung erhalten wird und die pro Schicht mindestens eine ladungstransportierende Verbindung, welche vernetzbare Gruppen tragen kann, enthält, dadurch gekennzeichnet, daß eine der Schichten ganz oder teilweise aus einer vernetzbaren fluoreszierenden Verbindung aufgebaut wird, welche radikalisch, anionisch oder kationisch vernetzbare oder zur Photocycloaddition fähige Gruppen enthält, die über Spacer an die fluoreszierenden Verbindungen gebunden sind, wobei als Spacer Gruppen der Formeln 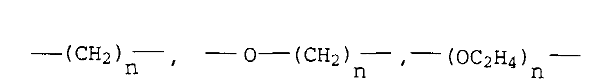 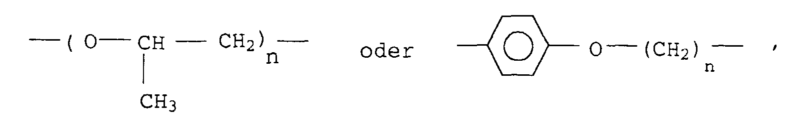 wobei n eine Zahl von 1 bis 12 bedeutet,
verwendet werden,
und daß die Verbindung Fluoreszenzlicht im Wellenlängenbereich von 400 bis 800 nm abstrahlt, ausgenommen die Verbindungen 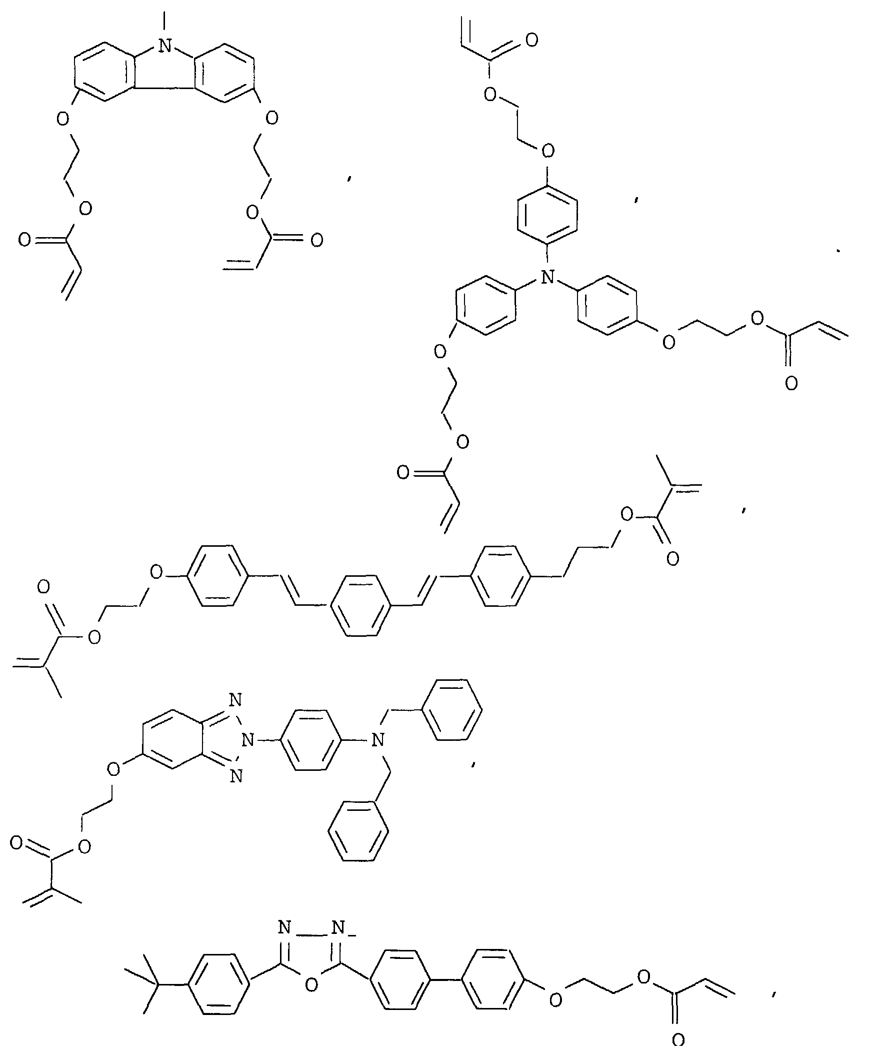 und 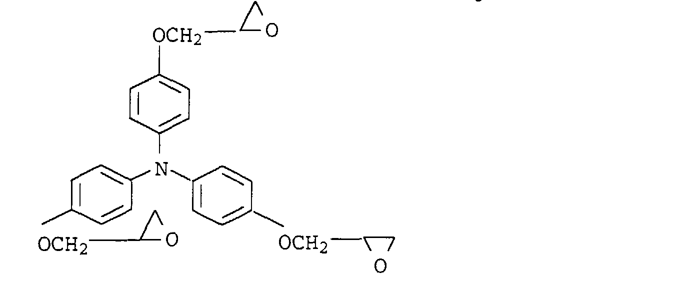 als fluoreszierende Verbindungen.

2. Elektrolumineszierende Anordnung nach Anspruch 1, dadurch gekennzeichnet, daß die Schichten eine Dicke zwischen 10 nm und 10 µm aufweisen.

3. Elektrolumineszierende Anordnung nach Anspruch 1, dadurch gekennzeichnet, daß die fluoreszierende Verbindung aus der Klasse der Perylene, Naphthalimide,Dibenzanthrone, Pyrene, Benztriazole, Oxadiazole, Bisstyryle, Benzoxazole, Cumarine, Violanthrone, Isoviolanthrone oder Benzofurane stammt.

4. Elektrolumineszierende Anordnung nach Anspruch 1, enthaltend zuzätzlich mindestens ein vernetzbares polymeres Bindemittel und/oder mindestens eine vernetzbare niedermolekulare Verbindung, wobei entweder die niedermolekulare Verbindung oder die ladungstransportierende Verbindung eine fluoreszierende Verbindung ist.

5. Elektrolumineszierende Anordnung nach den Ansprüchen 1 bis 4, dadurch gekennzeichnet, daß eine oder mehrere Schichten durch Vernetzung mit UV-Strahlung erhalten werden.

6. Elektrolumineszierende Anordnung nach den Ansprüchen 1 bis 4, dadurch gekennzeichnet, daß eine oder mehrere Schichten durch Vernetzung mit Elektronenstrahlen erhalten werden.

7. Elektrolumineszierende Anordnung nach den Ansprüchen 1 bis 6, dadurch gekennzeichnet, daß als fluoreszierende Verbindung eine Verbindung mit radikalisch polymerisierbaren Gruppen verwendet wird.

8. Elektrolumineszierende Anordnung nach Anspruch 7, dadurch gekennzeichnet, daß die fluoreszierende Verbindung als radikalisch polymerisierbare Gruppen gegebenenfalls substituierte Vinylreste trägt.

9. Elektrolumineszierende Anordnung nach den Ansprüchen 1 bis 6, dadurch gekennzeichnet, daß die zur Photocycloaddition fähigen Gruppen sich von folgenden Struktureinheiten 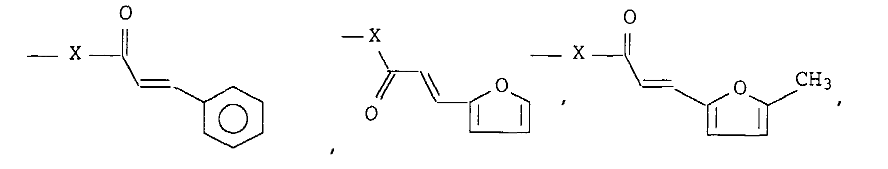 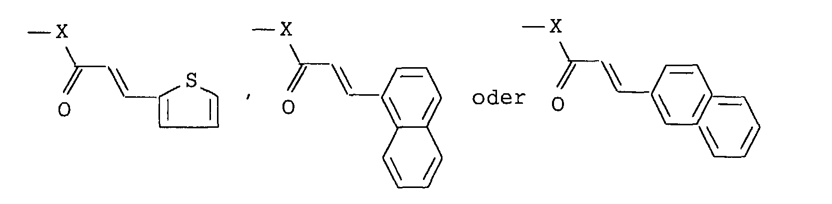 ableiten,
wobei X O oder NR ist, und R Wasserstoff oder C₁ bis C₆-Alkyl bedeutet.

10. Verfahren zur Herstellung einer elektrolumineszierenden Anordnung gemäß Anspruch 1, dadurch gekennzeichnet, daß man beim Aufbau der verschiedenen organischen Schichten mindestens eine Schicht, welche gewünschtenfalls auch die fluoreszierende Verbindung enthält, durch Auftragung einer Monomerlösung erhält, anschließend das Lösungsmittel entfernt und die Schicht dann thermisch oder strahlungsinduziert vernetzt.

## Claims

1. An electroluminescent arrangement containing one or more organic layers, at least one of which is obtained by thermal or radiation-induced crosslinking, and which contains at least one charge-transporting compound, which can carry crosslinkable groups, per layer, wherein one of the layers is completely or partially composed of a crosslinkable fluorescent compound, which contains groups capable of free radical, anionic or cationic crosslinking or of photocycloaddition and bonded to the fluorescent compounds via spacers, the spacers used being groups of the formulae 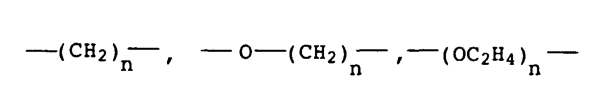 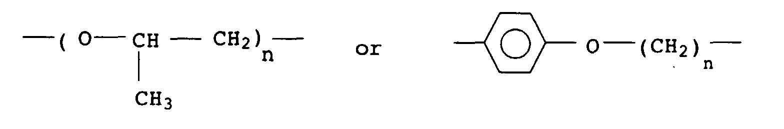 where n is from 1 to 12,
and wherein the compound emits fluorescent light in the wavelength range from 400 to 800 nm, excluding the compounds 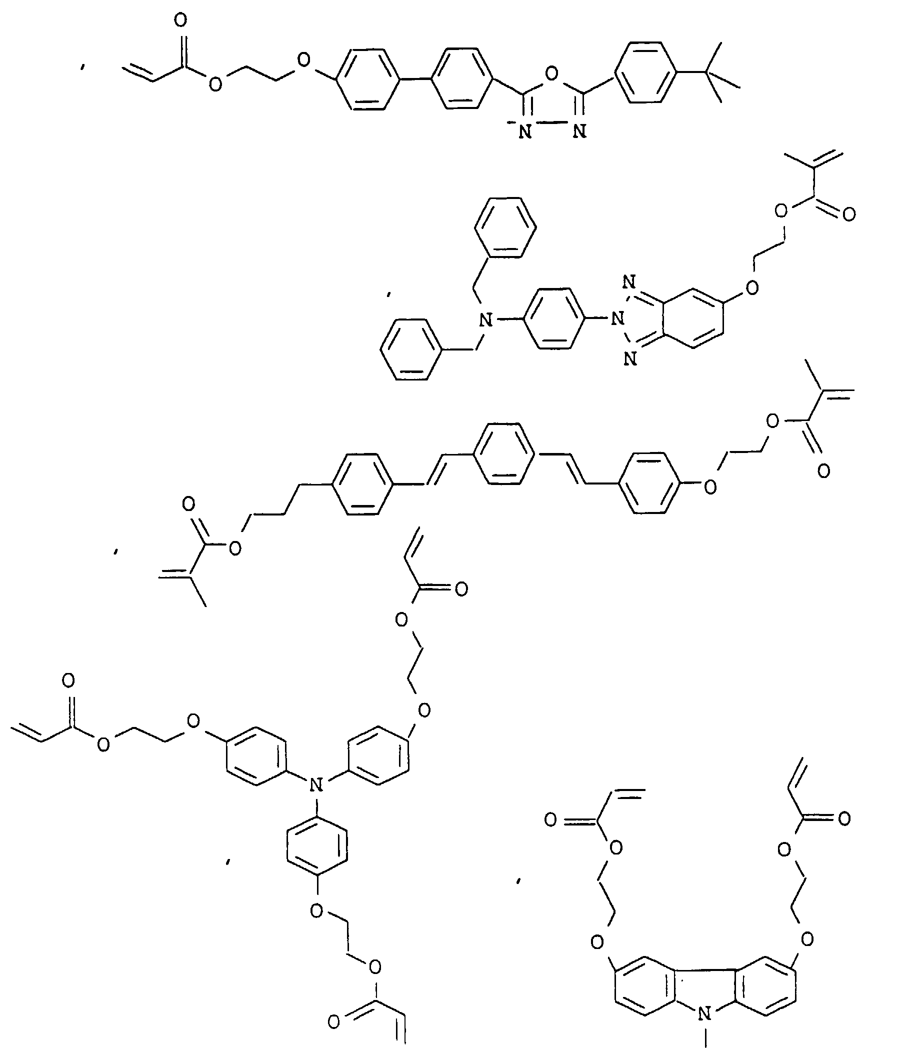 and 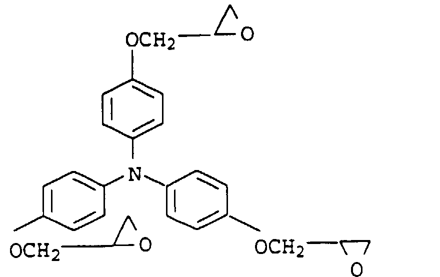 as fluorescent compounds.

2. An electroluminescent arrangement as claimed in claim 1, wherein the layers have a thickness of from 10 nm to 10 µm.

3. An electroluminescent arrangement as claimed in claim 1, wherein the fluorescent compound is derived from the class consisting of the perylenes, naphthalimides, dibenzanthrones, pyrenes, benzotriazoles, oxadiazoles, bistyryls, benzoxazoles, coumarins, violanthrones, isoviolanthrones or benzofurans.

4. An electroluminescent arrangement as claimed in claim 1, additionally containing at least one crosslinkable polymeric binder or at least one crosslinkable low molecular weight compound, either the low molecular weight compound or the charge-transporting compound being a fluorescent compound.

5. An electroluminescent arrangement as claimed in any of claims 1 to 4, wherein one or more layers are obtained by crosslinking with UV radiation.

6. An electroluminescent arrangement as claimed in any of claims 1 to 4, wherein one or more layers are obtained by crosslinking with electron beams.

7. An electroluminescent arrangement as claimed in any of claims 1 to 6, wherein the fluorescent compound used is a compound having groups capable of free radical polymerization.

8. An electroluminescent arrangement as claimed in claim 7, wherein the fluorescent compound carries unsubstituted or substituted vinyl radicals as groups capable of free radical polymerization.

9. An electroluminescent arrangement as claimed in any of claims 1 to 6, wherein the groups capable of photocycloaddition are derived from the following structural units 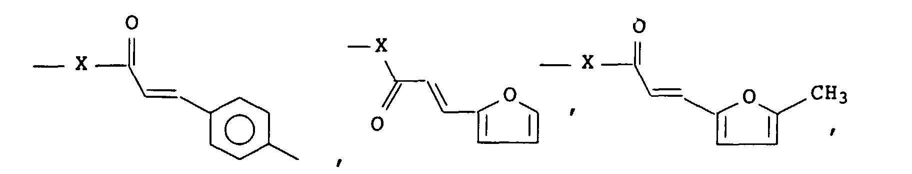 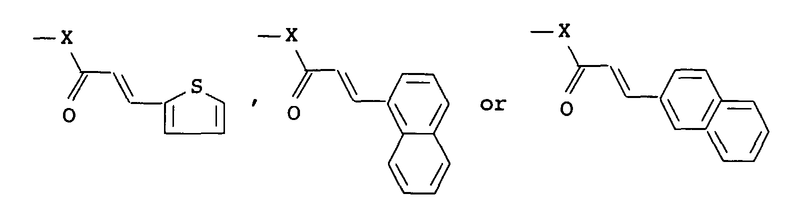 in which X is O or NR and R is hydrogen or C₁-C₆-alkyl.

10. A process for the preparation of an electroluminescent arrangement as claimed in claim 1, wherein, in the production of the various organic layers, at least one layer which, if desired, also contains the fluorescent compound is obtained by applying a monomer solution, the solvent is then removed and the layer is then crosslinked thermally or by means of radiation.

## Revendications

1. Dispositif électroluminescent contenant une ou plusieurs couches organiques, parmi lesquelles au moins une est obtenue par une réticulation thermique ou induite par des rayonnements, et qui contient au moins un composé de transport de charges par couche, lequel peut porter des groupements réticulables, caractérisé en ce que l'une des couches est totalement ou partiellement construite à partir d'un composé fluorescent réticulable, lequel contient des groupements réticulables de façon radicalaire, anionique ou cationique ou susceptibles de photocycloaddition, qui sont reliés au composé fluorescent par un espaceur, où l'on utilise comme espaceur des groupements de formules 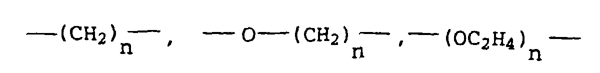 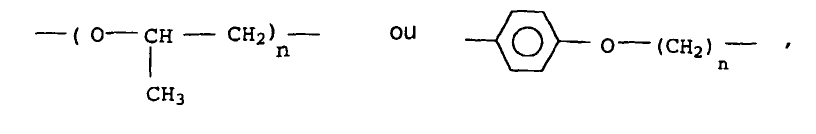 où n représente un nombre de 1 à 12,
et en ce que le composé émet une lumière de fluorescence dans le domaine de longueurs d'ondes de 400-800 nm; à l'exception des composés 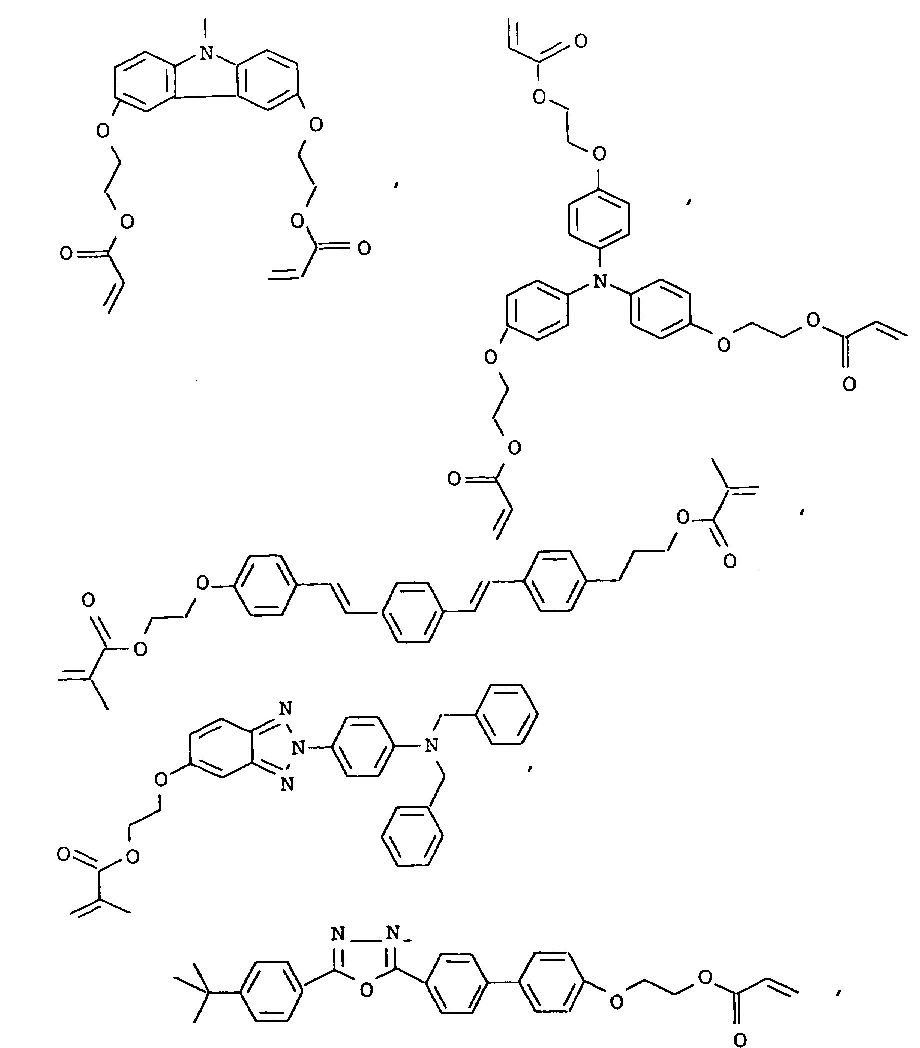 et 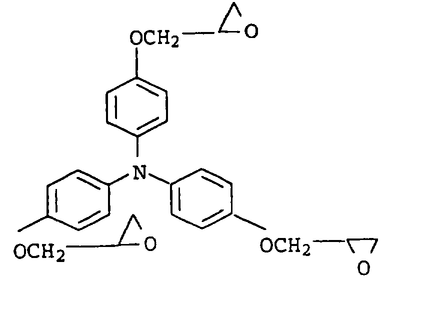 en tant que composés fluorescents.

2. Dispositif électroluminescent selon la revendication 1, caractérisé en ce que les couches présentent une épaisseur entre 10 nm et 10 µm.

3. Dispositif électroluminescent selon la revendication 1, caractérisé en ce que le composé fluorescent provient de la classe du pérylène, du naphtalimide, du dibenzanthrone, du pyrène, du benzotriazole, de l'oxodiazole, du bisstyryle, du benzoxazole, de la coumarine, de la violanthrone, de l'isoviolanthrone ou du benzofurane.

4. Dispositif électroluminescent selon la revendication 1, contenant en outre au moins un liant polymère réticulable et/ou au moins un composé réticulable à bas poids moléculaire, où soit le composé à bas poids moléculaire, soit le composé de transport de charges est un composé fluorescent.

5. Dispositif électroluminescent selon l'une quelconque des revendications 1 à 4, caractérisé en ce qu'une ou plusieurs des couches sont obtenues par réticulation au moyen d'un rayonnement UV.

6. Dispositif électroluminescent selon l'une quelconque des revendications 1 à 4, caractérisé en ce qu'une ou plusieurs des couches sont obtenues par réticulation au moyen d'un rayonnement électronique.

7. Dispositif électroluminescent selon l'une quelconque des revendications 1 à 6, caractérisé en ce que l'on utilise un composé ayant des groupements polymérisables de façon radicalaire, en tant que composé fluorescent.

8. Dispositif électroluminescent selon la revendication 7, caractérisé en ce que le composé fluorescent porte des restes vinyle éventuellement substitués en tant que groupements polymérisables de façon radicalaire.

9. Dispositif électroluminescent selon l'une quelconque des revendications 1 à 6, caractérisé en ce que les groupements susceptibles de photocycloaddition dérivent des unités structurelles suivantes : 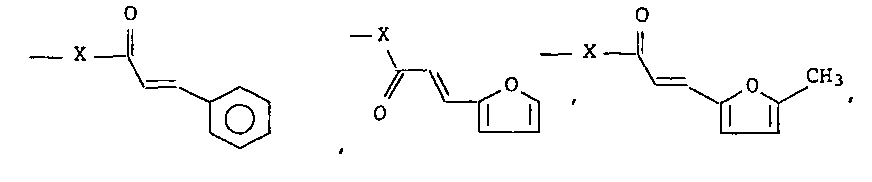 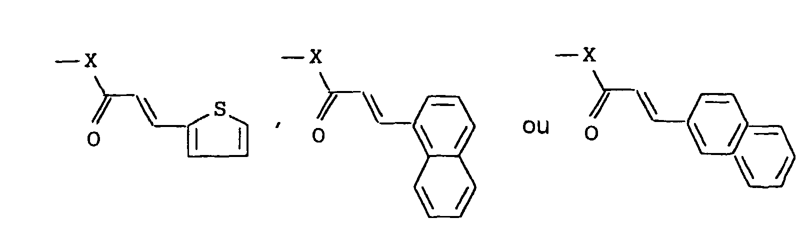 où X est O ou NR, et R représente un atome d'hydrogène ou un groupement alkyle en C₁-C₆.

10. Procédé de préparation d'un dispositif électroluminescent selon la revendication 1, caractérisé en ce que l'on obtient, au cours de la construction des différentes couches organiques, au moins une couche, contenant éventuellement aussi le composé fluorescent, par dépôt d'une solution de monomère, puis on élimine le solvant et l'on réticule la couche de façon thermique ou induite par des rayonnements.
